Europäisches Patentamt

European Patent Office

Office européen des brevets

(11) Veröffentlichungsnummer: **0 204 104**
**B1**

(12) **EUROPÄISCHE PATENTSCHRIFT**

(45) Veröffentlichungstag der Patentschrift: **26.09.90**

(51) Int. Cl.⁵: **G 01 N 24/10, G 01 R 33/60**

(21) Anmeldenummer: **86104886.6**

(22) Anmeldetag: **10.04.86**

(54) Resonatoranordnung.

(30) Priorität: **07.06.85 DE 3520410**

(43) Veröffentlichungstag der Anmeldung:
**10.12.86 Patentblatt 86/50**

(45) Bekanntmachung des Hinweises auf die
Patenterteilung:
**26.09.90 Patentblatt 90/39**

(84) Benannte Vertragsstaaten:
**CH DE FR GB LI NL**

(56) Entgegenhaltungen:
**DE-A-2 917 794**
**DE-A-3 300 767**
**Journal of Physics E, Vol. 16, Jänner 1983 F.
Momo et al. "On the design of a split ring
resonator for ESR spectroscopy between 1 and
4 GHz"**
**Journal of Magnetic Resonance, Vol. 47, 3. Mai
1982, Academic Press, New York, London W.
Fransisz et al. "The Loop-Gap Resonator: A New
Microwave Lumped Circuit ESR Sample
Structure"**

(73) Patentinhaber: **Bruker Analytische Messtechnik
GmbH
Silberstreifen
D-7512 Rheinstetten 4 (DE)**

(72) Erfinder: **Brunner, Hermann, Dr. Max-Planck-
Institut für
medizinische Forschung Jahnstrasse 29
D-6900 Heidelberg (DE)**
Erfinder: **Hausser, Karl Hermann, Dr. Max-
Planck-Institut für
fur medizinische Forschung Jahnstrasse 29
D-6900 Heidelberg (DE)**
Erfinder: **Veith, Werner, Dr. Max-Planck-Institut
für
medizinische Forschung Jahnstrasse 29
D-6900 Heidelberg (DE)**

(74) Vertreter: **Patentanwälte Kohler - Schwindling -
Späth
Hohentwielstrasse 41
D-7000 Stuttgart 1 (DE)**

# EP 0 204 104 B1

**Beschreibung**

Die Erfindung betrifft eine Resonatoranordnung, insbesondere für die ESR-Spektroskopie, mit einem Resonanzkreis, der wenigstens zwei durch Axialschlitze getrennte, den Umfang eines Resonatorraumes begrenzende, metallische Wandabschnitte aufweist, welche im wesentlichen die Induktivität des Resonanzkreises bestimmen, während die die Axialschlitze begrenzenden Stirnflächen der Wandabschnitte im wesentlichen die Kapazität des Resonanzkreises bestimmen, und mit einer die Wandabschnitte umgebenden metallischen Abschirmung, wobei die Wandabschnitte mit der Abschirmung durch eine metallische Struktur verbunden sind, die zum Resonatorraum achsparallele Kammern bilden, von denen jede über Axialschlitze mit dem Resonatorraum in Verbindung steht und in der zu ihrer Achse senkrechten Ebene einen Umfang hat, der wesentlich größer ist als die Ausdehnung jedes der Wandabschnitte zwischen jeweils zwei einander benachbarten Axialschlitzen.

Eine solche Resonatoranordnung ist aus der US-PS 44 80 239 bekannt. Dort ist allerdings die Abschirmung einstückig mit den Wandteilen des Resonatorraumes ausgeführt, wobei der Resonatorraum und die achsparallelen Kammern jeweils durch parallele, zylindrische durchgängige Bohrungen in einem Metallblock beliebiger Form gebildet werden, die durch gefräste Axialschlitze mit dem Resonatorraum und teilweise auch untereinander verbunden sind.

In dieser Anordnung wäre ein seitlicher Zugang zum Resonatorraum nur durch einen der Axialschlitze möglich, deren Breiten jedoch möglichst klein zu wählen sind, um die störenden elektrischen Feldlinien außerhalb des Resonatorraumes zu konzentrieren. Außerdem müßten Zusatzgeräte, die über den Schlitz auf den Resonatorraum einwirken sollen (z.B. zusätzliche HF-Spulen für bedarfsweise NMR-Anwendungen) in der entsprechenden achsparallelen Kammer angebracht werden, was zu einem groben Eingriff in das Resonanzsystem und mit Sicherheit zu einer Frequenzverstimmung führen würde.

Der Erfindung liegt daher die Aufgabe zugrunde, eine Resonatoranordnung gemäß dem Oberbegriff des Hauptanspruches dergestalt auszubilden, daß unabhängig von der axialen Zugänglichkeit des Resonatorraumes in einer Richtung senkrecht zur Resonatorachse ein bequemer Zutritt zum Innern des Resonatorraumes ermöglicht wird, der insbesondere den Durchtritt elektromagnetischer Strahlung zur Beobachtung bzw. Beeinflussung der Probe zuläßt, dabei aber trotz der notwendigen Offnungen in den Resonatorwänden die Abschirmung intakt läßt und ein homogenes Magnetfeld innerhalb des Resonatorraumes gewährleistet.

Diese Aufgabe wird nach der Erfindung dadurch gelöst, daß wenigstens zwei einander gegenüberliegende Wandabschnitte des Resonatorraumes durch in Umfangsrichtung jeweils bis zu den Axialschlitzen reichende Offnungen im wesentlichen auf zwei parallele, an den Enden des Resonatorraumes angeordnete Leitungsabschnitte reduziert sind, deren Abstand etwa gleich dem Radius des Resonatorraumes ist. Diese Ausbildung der Resonatoranordnung bietet einen freien radialen Zutritt zum Resonatorraum und dient zur Homogenisierung des Magnetfeldes im Resonatorraum, da dann, wenn die von den Randbereichen der Wandung gebildeten Leitungsabschnitte einen Abstand haben, der etwa gleich dem Radius des Resonatorraumes ist, diese Leitungsabschnitte den Wicklungsabschnitten einer Helmholtz-Spule entsprechen, die ein sehr homogenes Magnetfeld erzeugt.

Eine für die Herstellung und die Montage einer solchen Resonatoranordnung besonders vorteilhafte Ausführung besteht darin, daß der Resonatorraum, die Kammern und die den Resonatorraum mit den Kammern verbindenden Axialschlitze von Aussparungen in einem in die Abschirmung eingesetzten metallischen Körper gebildet werden. Bei einer solchen Resonatoranordnung läßt sich der metallische Körper separat leicht herstellen und mit den gewünschten Aussparungen versehen, und es ist ein solcher Körper in ein als Abschirmung dienendes Rohr leicht einsetzbar. Dabei können die den Resonatorraum und die Kammern bildenden Aussparungen in besonders einfacher Weise aus zylindrischen Bohrungen bestehen, die dann durch eingesägte oder eingefräste Schlitze miteinander verbunden sind. Dabei ist es auch leicht möglich, auf den Umfang des Resonatorraumes eine Vielzahl Kammern verteilt anzuordnen. Die Anwendung von mehreren auf den Umfang des Resonatorraumes verteilten Kammern hat den Vorteil, daß die durch die auf die Axialschlitze konzentrierten elektrischen Felder bedingten Ungleichförmigkeiten des Magnetfeldes im Resonatorraum in hohem Maße ausgeglichen werden und auf eine schmale Randzone beschränkt bleiben. Weiterhin lassen sich solche Anordnungen in der Weise herstellen, daß die axialen Schlitze zwischen dem Resonatorraum und den Kammern in Radialrichtung eine erhebliche Ausdehnung haben, wodurch die Kapazitäten gegenüber den bekannten Resonatoranordnungen stark erhöht werden. Dadurch wird erreicht, daß das elektrische Feld im wesentlichen auf das Innere der Axialschlitze beschränkt bleibt.

In weiterer Ausgestaltung der Erfindung ist der Innendurchmesser der Abschirmung so klein, daß in der Nähe der Arbeitsfrequenz des Resonanzkreises innerhalb der Abschirmung keine Hohlraumresonanzen angeregt werden, die das Auffinden der Kreisresonanz erschweren. Solche Störresonanzen können bei Abschirmungen mit größeren Innendurchmessern vor allem dann auftreten, wenn zusätzliche NMR-Spulen in den Abschirmungszylinder eingebracht werden. Auch wird dann verhindert, daß bei der Arbeitsfrequenz des Resonanzkreises innerhalb der Abschirmung Hohlleiterwellen angeregt werden, die möglicherweise abgestrahlt werden und erhebliche Störungen verursachen könnten, zumindest aber einen erheblichen Energieverlust darstellen würden und eine starke Bedämpfung des Resonanzkreises zur Folge hätten.

Häufig ist es erforderlich, ESR-Experimente mit NMR-Experimenten zu kombinieren, wozu die im Resonatorraum enthaltene Probe mit einer im Bereich zwischen 10 und 100 MHz liegenden Frequenz angeregt werden muß. Bei den Dimensionen der erfindungsgemäßen Resonatoranordnung muß zu diesem Zweck eine besondere HF-Spule Anwendung finden. Bei der erfindungsgemäßen Resonatoranordnung kann eine solche HF-Spule an der Außenseite der Wandabschnitte angeordnete, entweder jeweils einen von zwei einander gegenüberliegenden Axialschlitzen umgebenden oder einer von zwei ineinander gegenüberliegenden Wandabschnitten angeordneten Öffnungen benachbarte Wicklungsabschnitte aufweisen. Statt dessen besteht auch die Möglichkeit, die Resonatoranordnung mit einer HF-Spule zu versehen, die parallel zu den offenen Enden des Resonatorraumes angeordnete Wicklungsabschnitte aufweist. In diesem Falle wäre das Magnetfeld der HF-Spule nicht zu dem Magnetfeld im Resonatorraum senkrecht, sondern parallel angeordnet. In jedem Fall werden die Abmessungen und Abstände der Wicklungsabschnitte so gewählt, daß sie wiederum eine Helmholtz-Spule bilden, damit das im Bereich zwischen den Wicklungsabschnitten erzeugte Magnetfeld möglichst homogen ist.

Die mit dem Resonatorraum verbundenen Kammern gestatten auch in gewissen Grenzen ein Verändern der Resonanzfrequenz der Resonatoranordnung durch Beeinflussung des in der Kammer bzw. von der Kammer zum Resonatorraum übertretenden Feldes. Daher ist in weiterer Ausgestaltung der Erfindung vorgesehen, daß in wenigstens eine der Kammern ein dielektrisches oder metallisches Abstimmglied hineinragt. Auch hier ist wieder von besonderem Vorteil, daß die zum Verstimmen notwendigen Eingriffe im Bereich einer solchen Kammer keine Rückwirkungen auf die Ausbildung des Magnetfeldes im Resonanzraum haben und daß außerdem der Zugang zum Resonanzraum nicht behindert wird.

Bei sehr empfindlichen Elektronenspin-Resonanz-Messungen, insbesondere bei der Messung von kurzen Relaxationszeiten mit ESR-Puls-Spektrometern, werden oft bimodale Mikrowellen-Schwingkreise benutzt, die in einem vorgegebenen Bereich orthogonale magnetische Felder gleicher Frequenz erzeugen. Solche Anordnungen sind beispielsweise in der DE-PS 16 98 223 und der DE-OS 29 17 794 beschrieben. Die erfindungsgemäße Resonatoranordnung ermöglicht es auch, einen bimodalen Mikrowellen-Schwingkreis herzustellen, der alle die Vorteile aufweist, die vorstehend für die erfindungsgemäße Resonatoranordnung geltend gemacht worden sind. Dabei macht die bimodale Resonatoranordnung nach der Erfindung von metallischen Körpern Gebrauch, welche den Resonatorraum, die Kammern und die Axialschlitze enthalten und bei denen wenigstens zwei einander gegenüberliegende Wandabschnitte des Resonatorraumes Öffnungen aufweisen. In weiterer Ausgestaltung der Erfindung werden zwei solcher metallischer Körper so miteinander kombiniert, daß der Resonatorraum des einen metallischen Körpers von einem den Resonatorraum, die Kammern und die verbindenden Axialschlitze eines zweiten Resonanzkreises enthaltenden Körper in der Weise durchsetzt wird, daß die Achsen der Resonatorräume im wesentlichen senkrecht aufeinanderstehen und die Enden des Resonatorraumes des zweiten, inneren Resonanzkreises Öffnungen in den Wandabschnitten des ersten, äußeren Resonanzkreises gegenüberstehen.

Bei dieser Konfiguration weisen die Wandungen der beiden Resonatorräume ausreichend große Öffnungen in einer Zuordnung auf, daß die Felder der einzelnen Resonatoranordnungen nicht wesentlich gestört werden, so daß in dem Resonatorraum des inneren Resonanzkreises außer dem diesem zweiten Resonanzkreis eigenen Magnetfeld auch das Magnetfeld des äußeren Resonanzkreises herrscht. Weiterhin lassen sich auch hier bei der erfindungsgemäßen Ausbildung der einzelnen Resonanzkreise die vorhandenen Öffnungen so miteinander zur Deckung bringen, daß das Einführen einer Probe ungehindert stattfinden kann und außerdem auch ein Lichtzutritt möglich ist. Ferner sind auch hier äußere Spulen zur Erzeugung eines NMR-Feldes möglich. Zugleich wird hier wieder eine mechanisch und thermisch und damit auch elektrisch sehr stabile Ganzmetall-Anordnung erzielt, die allen Anforderungen optimal gerecht wird. Trotzdem lassen sich Verstellmöglichkeiten vorsehen, die ein sehr genaues Einjustieren der Orthogonalität der Magnetfelder gestatten. So kann beispielsweise der den inneren Resonanzkreis enthaltende Körper an seinen Enden um eine mit der Achse des Resonatorraumes des äußeren Resonanzkreises im wesentlichen zusammenfallende Achse in den Wandungen der Abschirmung drehbar gelagert sein.

Weitere Einzelheiten und Ausgestaltungen der Erfindung ergeben sich aus der Beschreibung der in der Zeichnung dargestellten Ausführungsbeispiele. Die der Beschreibung und der Zeichnung zu entnehmenden Merkmale können bei anderen Ausführungsformen der Erfindung einzeln für sich oder zu mehreren in beliebiger Kombination Anwendung finden. Es zeigen

Fig. 1 eine schematische, perspektivische Darstellung einer Resonatoranordnung nach der Erfindung,

Fig. 2 die schematische Darstellung zweier Resonanzkreise, die insbesondere für den Aufbau eines bimodalen Resonators geeignet sind, und

Fig. 3 eine schematische perspektivische Darstellung eines bimodalen Resonators nach der Erfindung.

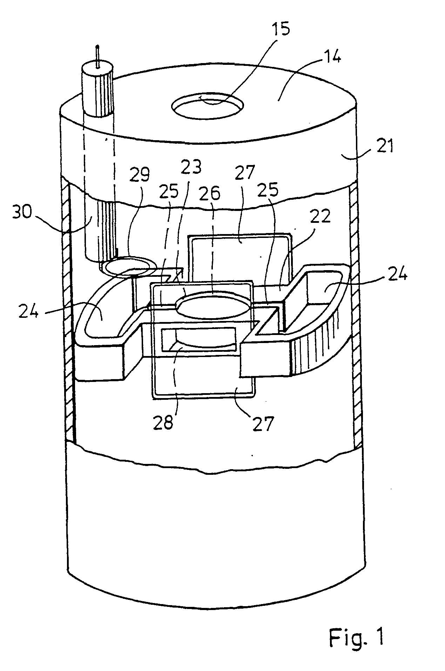

Fig. 1 veranschaulicht eine Ausführungsform der erfindungsgemäßen Resonatoranordnung, bei der in die Abschirmung 21 ein metallischer Körper 22 eingesetzt ist, der eine zentrale Bohrung aufweist, die den Resonatorraum 23 bildet, und zwei periphere Aussparungen, welche zu dem Resonatorraum 23 achsparallele, mit dem Resonatorraum 23 durch Axialschlitze 25 verbundene Kammern 24 bilden. Dabei ist gewährleistet, daß der Umfang der Kammern 24, die sich über einen erheblichen Winkelbereich des Querschnittes der Abschirmung 21 erstrecken, wesentlich größer ist als die Ausdehnung der Wandabschnitte 26, die sich zwischen den beiden einander gegenüberliegenden Axialschlitzen 25 befinden.

3

Die Wandungsabschnitte 26 bilden einen Resonanzkreis, dessen Resonanzfrequenz durch die von den Wandabschnitten 26 gebildeten Induktivitäten und die von den dazu jeweils in Serie geschalteten, von den einander gegenüberstehenden Flächen der Axialschlitze 25 gebildeten Kapazitäten bestimmt wird. Allerdings wird diese Resonanzfrequenz auch durch die Abmessungen der äußeren Kammern 24 beeinflußt. Die Abmessungen der Resonatoranordnung sind jedoch so gewählt, daß die Resonanzfrequenz des Resonanzkreises kleiner ist als die Grenzfrequenz des von der Abschirmung 21 gebildeten Hohlleiterabschnittes, so daß innerhalb der Abschirmung keine Hohlleiter-Wellentypen möglich sind, deren Frequenz gleich der Resonanzfrequenz des Resonanzkreises ist. Da der Umfang der Kammern 24 in einer zur Achse des Resonatorraumes 23 senkrechten Ebene im Vergleich zu der in der gleichen Ebene gemessenen Länge der Wandabschnitte sehr groß ist, ist auch die von der Kammerwandung gebildete Induktivität vergleichsweise groß, so daß sie die Resonanzfrequenz des Resonanzkreises nicht stark beeinflußt. Grundsätzlich bildet diese Induktivität einen Parallelwiderstand zu der von dem Axialspalt 25 gebildeten Kapazität, dessen Einfluß umso geringer ist, je größer er im Verhältnis zu dem von der Kapazität des Axialspaltes 25 gebildeten Widerstand ist.

Der Vorteil der Anordnung besteht darin, daß die Resonatoranordnung ein einheitliches, aus dem gleichen Material bestehendes Gebilde darstellt, das sowohl eine hohe mechanische als auch thermische Stabilität aufweist und daher auch für den Betrieb bei Tiefsttemperaturen sehr gut geeignet ist. Die Ausbildung des Resonanzkreises gewährleistet die Erzeugung eines HF-Magnetfeldes guter Homogenität innerhalb des Resonatorraumes, in den die hohen elektrischen Felder der Kapazitäten nur im Bereich der Axialschlitze 25 in geringem Maße eindringen. Das Einführen einer Probensubstanz in den Resonatorraum 23 kann in Axialrichtung des Resonatorraumes durch dessen offene Enden hindurch erfolgen. Zu diesem Zweck weist bei dem dargestellten Ausführungsbeispiel die Stirnwand 14 der Abschirmung 21 eine konzentrische Öffnung 15 auf. Weiterhin besteht die Möglichkeit, in die Abschirmung 21 die Felder in den Kammern 24 beeinflussende Elemente radial oder axial einzuführen, beispielsweise an die Axialschlitze angrenzende dielektrische Körper oder aber auch metallische Körper, wodurch es möglich ist, die Resonanzfrequenz des Resonanzkreises in gewissen Grenzen zu verändern.

Bei dieser Ausführungsform der Erfindung ist eine HF-Spule für NMR-Experimente vorgesehen, die zwei Wicklungsabschnitte 27 aufweist. Diese Wicklungsabschnitte sind jeweils einer Öffnung 28 benachbart, die in dem entsprechenden Wandabschnitt 26 angebracht ist und sich jeweils bis zu den angrenzenden Axialschlitzen 25 erstreckt. Durch diese Öffnungen 28 werden die Wandabschnitte 26 auf schmale Leitungsabschnitte reduziert, die den Wandabschnitten den Charakter einer Wicklung geben. Die Dimensionen des metallischen Körpers und seiner Aussparungen sind so gewählt, daß der Abstand zwischen den Leitungsabschnitten, auf welche die Wandabschnitte 26 reduziert sind, etwa gleich dem Radius des Resonatorraumes ist. Dadurch werden Verhältnisse geschaffen, die denen einer Helmholtz-Spule entsprechen, wodurch gewährleistet ist, daß trotz der Öffnungen 28 in den Wandabschnitten 26 das Magnetfeld innerhalb des Resonatorraumes 23 homogen ist. Die Öffnungen 28 gewährleisten einen guten Eintritt des von den Wicklungsabschnitten 27 der HF-Spule erzeugten Magnetfeldes, das bei dieser Anordnung senkrecht zu dem im Resonatorraum 23 herrschenden Mikrowellen-Magnetfeld steht.

Bei dieser Darstellung sind Einzelheiten über die leitende Verbindung der Wicklungsabschnitte und deren elektrischen Anschluß an einen HF-Generator fortgelassen. Schematisch dargestellt ist eine Koppelschleife 29, die sich am Ende einer Koaxialleitung 30 befindet. Diese Koaxialleitung ist in die Abschirmung 21 parallel zu deren Achse eingeführt und steht mit ihrem Ende einer der Kammern 24 gegenüber. Die Koppelschleife 29 ist so angeordnet, daß ihre Fläche zur Stirnfläche der Kammer 24 parallel verläuft. Infolgedessen müssen die aus der Kammer 24 austretenden und in den Resonatorraum 26 eintretenden Feldlinien die Schleife 29 durchdringen. Der Ankopplungsgrad kann leicht dadurch geändert werden, daß die Kopplungsschleife der Kammer 24 mehr oder weniger genähert wird.

Ein besonderer Vorteil dieser Ausführungsform der Erfindung besteht nicht nur darin, daß der metallische Körper mit seinen Aussparungen leicht gesondert hergestellt und dann innerhalb der Abschirmung befestigt werden kann, sondern auch darin, daß die die Wandungsabschnitte des Resonatorraumes voneinander trennenden Axialschlitze 25 auch in Radialrichtung eine erhebliche Ausdehnung haben, so daß große Flächen entstehen, welche entsprechend große Kapazitäten bilden, und die Konzentration des elektrischen Feldes auf den Bereich der Axialschlitze 25 verbessert wird. Da bei ESR-Experimenten das elektrische Feld stört, wird bei dieser Ausführungsform der Erfindung ein besonders großer Bereich innerhalb des Resonatorraumes geschaffen, in dem praktisch nur ein Magnetfeld herrscht, das zugleich auf den engen Resonatorraum konzentriert ist und daher die gewünschte hohe Feldstärke besitzt.

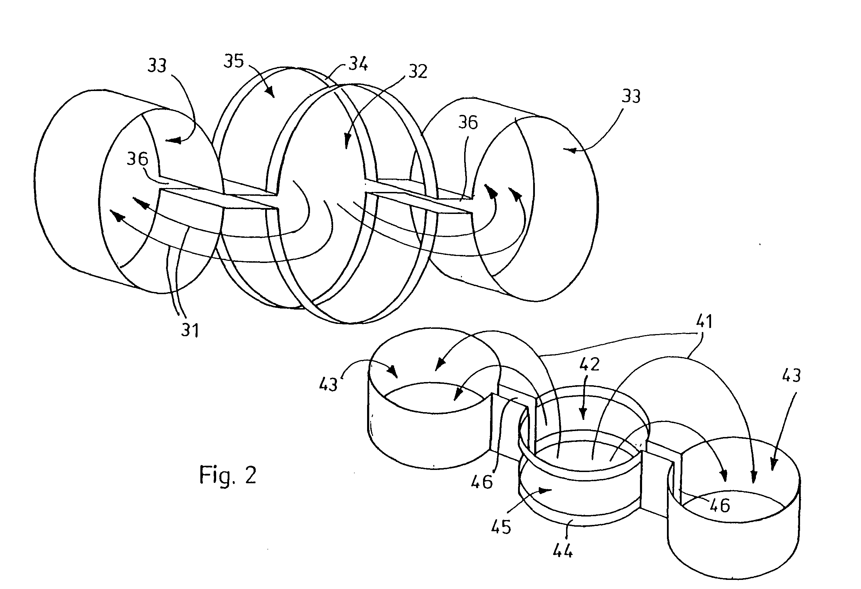

Obwohl der Resonatorraum und die damit durch die Axialschlitze verbundenen Kammern an ihren Enden offen sind, sind für die elektrische Funktion im wesentlichen nur die Innenflächen der Räume wirksam. Es ist deshalb ohne weiteres möglich, die Wandstärke der die Aussparungen aufweisenden metallischen Körper so weit zu reduzieren, wie es die mechanische Stabilität zuläßt. Es könnten also die metallischen Körper auch die in Fig. 2 dargestellte Form annehmen und beispielsweise als Blechteile ausgebildet sein. Von Bedeutung für die Funktion dieser Resonanzkreise ist, daß das magnetische Feld, dessen Verlauf in Fig. 2 durch die Linien 31, 41 veranschaulicht ist, im wesentlichen auf das Innere des Resonatorraumes 32, 42 und der Kammern 33, 43 beschränkt ist, wobei die an den Innenseiten der Kammern fließenden Ströme mit dem Rückkehrfeld verknüpft sind. Die Feldlinien schließen sich lediglich

EP 0 204 104 B1

jeweils in den an die Stirnflächen des Resonanzkreises angrenzenden Räumen. Da die Resonanzfrequenz des Kreises von dem produkt aus Induktivität und Kapazität abhängig ist, lassen sich durch gegensinniges Andern von Induktivität und Kapazität Resonanzkreise mit gleicher Resonanzfrequenz, aber unterschiedlichen Dimensionen herstellen. Dabei hat auch, wie oben dargelegt, die Größe der Kammern noch einen gewissen Einfluß. Um diesen Einfluß praktisch festzustellen, wurden Versuche unternommen, bei denen bei einem Durchmesser des Resonatorraumes von 6 mm kreisrunde Kammern mit unterschiedlichem Durchmesser sowie nierenförmige Kammern ähnlich der Ausführungsform nach Fig. 1 verwendet wurden. Für die nierenförmigen Kammern, aber auch für die kreisrunden Kammern ist jeweils der Umfang angegeben. Es wurden dabei die folgenden Frequenzen gemessen:

| Kammer-Durchmesser bzw. -Form | 5 mm | 6 mm | 7 mm | nierenförmig | |
|---|---|---|---|---|---|
| Kammer-Umfang | 14,6 mm | 17,8 mm | 21 mm | 29 mm | 45 mm |
| Frequenz | 9,03 GHz | 8,4 GHz | 7,825 GHz | 7,52 GHz | 7,2 GHz |

Wie bereits oben erwähnt, ist die von der Kammer gebildete Induktivität der Kapazität parallel geschaltet, so daß sie den kapazitiven Widerstand umso stärker mindert, je kleiner ihr induktiver Widerstand ist. Daher wirkt eine Kammer mit kleinem Umfang und entsprechend kleinem induktivem Widerstand stark frequenzerhöhend. Bei Vergrößerung des Umfanges nimmt die Kapazität also zu, so daß bei gleichbleibender Induktivität des Resonatorraumes die Frequenz abnimmt. Umgekehrt nimmt der auf den Resonatorraum konzentrierte Energieanteil des Magnetfeldes zu, je größer die äußeren Kammern sind, geringer also ihr Beitrag zur Gesamtinduktivität des Resonanzkreises ist. Bei einem Resonanzkreis mit zwei Kammern in der vorstehend behandelten "Hantelform" und einem Durchmesser des Resonatorraumes von 6 mm befinden sich 58% der HF-Energie im Resonatorraum, wenn der Durchmesser der Kammern 5 mm beträgt. Bei einer Vergrößerung der Kammern auf 6 mm Durchmesser steigt der Energieanteil auf 66,7%, bei 7 mm Kammer-Durchmesser auf 73%, und bei 9 mm Kammer-Durchmesser sogar auf 82%. Da der Kammer-Durchmesser im Hinblick auf den dadurch benötigten Platzbedarf und die Notwendigkeit, den Durchmesser der Abschirmung im Hinblick auf die Grenzfrequenz des von der Abschirmung gebildeten Hohlleiters klein zu halten, nicht beliebig vergrößert werden kann, ist eine Abweichung vom kreisförmigen Querschnitt der Kammern auf sektor- oder nierenförmige Gestalt häufig geboten.

Eine weitere Möglichkeit, den Einfluß der Kammern zu vermindern, besteht darin, mehr als nur zwei Kammern auf dem Umfang des Resonatorraumes anzuordnen und durch Axialschlitze mit dem Resonatorraum zu verbinden. Aber auch bei Resonanzkreisen mit vier oder gar acht Axialschlitzen ist es zweckmäßig, von der Kreisform abweichende Kammern zu verwenden.

Vielschlitzanordnungen haben drei wesentliche Vorteile, nämlich neben dem bereits erwähnten guten Wirkungsgrad auch ein homogenisiertes $H_1$-Feld in azimutaler Richtung sowie ein vermindertes elektrisches HF-Feld im zentralen Bereich. Es ist ohne weiteres ersichtlich, daß das Feld innerhalb des Resonatorraumes keine vollkommene Kreissymmetrie, sondern wegen der Konzentration des elektrischen Feldes auf die Axialschlitze eine gewisse Periodizität aufweist. Bei einem Kreis mit zwei Axialschlitzen existiert noch eine deutliche Zweier-Symmetrie. Je höher die Anzahl der Axialschlitze ist, umso stärker nimmt der Einfluß der einzelnen Schlitze und damit die Periodizität der Feldverteilung immer stärker ab. Diese Erscheinung hängt auch damit zusammen, daß bei einer Erhöhung der Anzahl der Axialschlitze die von den Wandungen dieser Axialschlitze gebildeten Kapazitäten immer größer werden müssen, so daß eine immer stärker werdende Konzentration des elektrischen Feldes auf diese Schlitze stattfindet und die die Periodizität bedingenden elektrischen Feldkomponenten immer weniger in den Resonatorraum eindringen.

Die in Fig. 2 dargestellten beiden Resonanzkreise sind so ausgebildet, daß der den Resonanzraum 42 des unteren Resonanzkreises bildende Abschnitt in den Resonanzraum 32 des oberen Resonanzkreises hineinpaßt, so daß also die beiden Resonanzkreise miteinander zu einer Struktur kombiniert werden können, in der die Achsen der Resonanzräume 32, 42 und damit auch die darin herrschenden Magnetfelder aufeinander senkrecht stehen. Es herrschen dann also am gleichen Ort zwei orthogenale und damit entkoppelte Magnetfelder gleicher Frequenz. Solche Magnetfelder werden beispielsweise für Elektronenspin-Doppelresonanz-Messungen und für besonders empfindliche ESR-Messungen benötigt.

Bei der Kombination der beiden Resonanzkreise nach Fig. 2 ist von Bedeutung, daß die Wandungen 34, 44 der Resonanzräume 32, 42 wiederum mit sehr großen Öffnungen 35, 45 versehen sind, durch die jeweils das vom anderen Resonanzkreis erzeugte Magnetfeld hindurchtreten kann. Weiterhin ist für die Ausbildung eines bimodalen Resonators von Bedeutung, daß bei den hier verwendeten hantelartigen Strukturen, wie bereits oben dargelegt, das Magnetfeld jeweils auf die Umgebung der durch die Axialschlitze 36, 46 definierten Ebenen beschränkt ist und daher auch keine Störung im Bereich der Außenfelder eintritt.

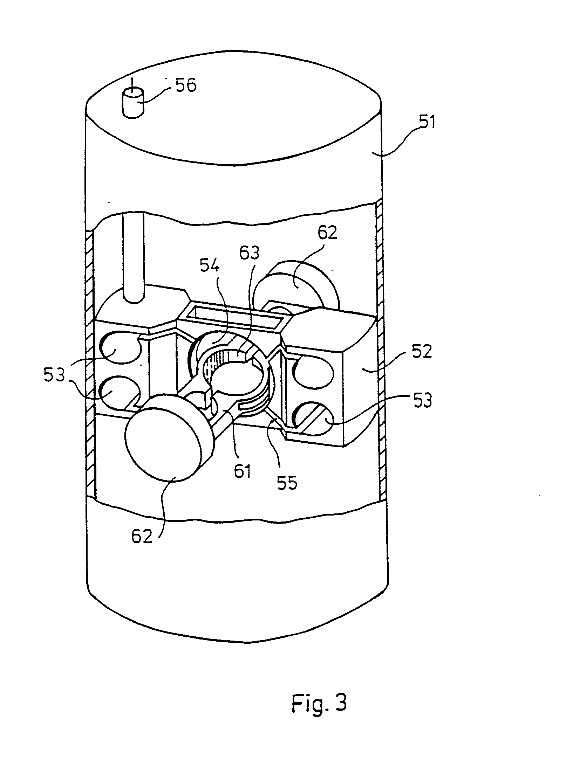

Fig. 3 zeigt eine praktische Ausführungsform einer solchen bimodalen Resonatoranordnung. Bei dieser Ausführunsform der Erfindung ist in die Abschirmung 51 ein erster Metallblock 52 eingesetzt, der dem Metallblock der Resonatoranordnung nach Fig. 1 ähnlich ist, jedoch anstatt zweier nierenförmiger Kammern vier kreisförmige Kammern 53 aufweist, die mit dem zentralen Resonatorraum 54 durch Axialschlitze 55 verbunden sind, die in einem Winkelabstand von 90° auf den Umfang des Resonatorraumes 54 verteilt sind. Die Kammern 53 sind in bezug auf die Axialschlitze 55 asymmetrisch angeordnet, so daß sie dicht nebeneinander liegen und das diese Kammern durchdringende Magnetfeld auch bei dieser Ausführungsform auf die Umgebung einer Ebene beschränkt bleibt. Der zweite Resonanzkreis wird ebenfalls von einem Block 61 gebildet, der in der Abschirmung 51 diametral angeordnet ist und dessen Abmessungen so gewählt sind, daß er durch den Resonatorraum 54 des ersten Resonanzkreises hindurchpaßt. An den Enden des Blockes 61 befinden sich zapfenartige Ansätze 62, mit denen der zweite Resonanzkreis in den Wandungen der Abschirmung 51 um seine Längsachse schwenkbar gelagert ist. Diese Schwenkbarkeit ermöglicht eine genaue Justierung der Orthogonalität der Achsen der beiden Resonanzräume 54 und 63. Die Ankopplung an den äußeren Resonanzkreis erfolgt mittels einer Koaxialleitung 56, die wiederum axial in der Abschirmung 51 angeordnet ist und an ihrem Ende eine in eine der Kammern 53 hineinragende Schleife aufweist. Die Ankopplung an den zweiten Resonanzkreis kann mit einer Schleife erfolgen, wie sie bei der Ausführungsform nach Fig. 1 vorhanden ist. Auch hier können die bereits erwähnten Abstimmittel dazu verwendet werden, beide Resonanzkreise auf genau die gleiche Resonanzfrequenz abzustimmen, was insbesondere dann erforderlich sein kann, wenn beide Resonanzkreise bei der Abkühlung auf Tiefsttemperaturen ihre Resonanzfrequenz auf unterschiedliche Weise ändern. Allerdings kann es für manche Zwecke notwendig sein, die Güte der Kreise durch bedämpfende Maßnahmen, beispielsweise durch die Ankopplung von Widerständen mittels einer weiteren Koppelschleife, auf relativ niedrige Werte zu bringen, bei denen geringe Unterschiede in der Resonanzfrequenz keine Rolle spielen.

Es versteht sich, daß die Erfindung nicht auf die ohnehin nur schematisch dargestellten Ausführungsbeispiele beschränkt ist, sondern daß Abweichungen davon möglich sind, ohne den Rahmen der Erfindung zu verlassen. Insbesondere können die Resonanzkreise jede beliebige, auch ungerade Anzahl von Kammern aufweisen, und es können diese Kammern beliebige Querschnitte haben. Auch könnte es beispielsweise zweckmäßig sein, die Axialschlitze in Richtung auf diese Kammern aufzuweiten, so daß zumindest in einem benachbarten Randbereich der Kammern ein elektrisches Feld vorliegt, das zu Abstimmzwecken eine Beeinflussung der Kapazität des Resonanzkreises zuläßt. Neben Abstimmaßnahmen sind auch Maßnahmen zur mehr oder weniger starken Bedämpfung der Kreise denkbar. Das Ein- und Auskoppeln von Energie kann durch Anwendung gemeinsamer oder getrennter Koppelelemente erfolgen, und es können auch statt Schleifen in der aus der Mikrowellentechnik bekannten Weise Antennen als Koppelelemente Anwendung finden. Auch brauchen die Koppelelemente nicht axial in die Abschirmung eingeführt zu werden, sondern können durch entsprechende Öffnungen auch radial in den abgeschirmten Bereich hineinragen.

**Patentansprüche**

1. Resonatoranordnung, insbesondere für die ESR-Spektroskopie, mit einem Resonanzkreis, der wenigstens zwei durch Axialschlitze getrennte, den Umfang eines Resonatorraumes begrenzende, metallische Wandabschnitte aufweist, welche im wesentlichen die Induktivität des Resonanzkreises bestimmen, während die die Axialschlitze begrenzenden Stirnflächen der Wandabschnitte im wesentlichen die Kapazität des Resonanzkreises bestimmen, und mit einer die Wandabschnitte umgebenden metallischen Abschirmung, wobei die Wandabschnitte mit der Abschirmung durch eine metallische Struktur verbunden sind, die zum Resonatorraum achsparallele Kammern bildet, von denen jede über Axialschlitze mit dem Resonatorraum in Verbindung steht und in der zu ihrer Achse senkrechten Ebene einen Umfang hat, der wesentlich größer ist als die Ausdehnung jedes der Wandabschnitte zwischen jeweils zwei einander benachbarten Axialschlitzen, dadurch gekennzeichnet, daß wenigstens zwei einander gegenüberliegende Wandabschnitte (26) des Resonatorraumes (23) durch in Umfangsrichtung jeweils bis zu den Axialschlitzen (25) reichende Öffnungen (28) im wesentlichen auf jeweils zwei parallele, bezüglich der Achsrichtung an den Enden des Resonatorraumes angeordnete Leitungsabschnitte reduziert sind, deren Abstand etwa gleich dem Radius des Resonatorraumes ist.

2. Resonatoranordnung nach Anspruch 1, dadurch gekennzeichnet, daß der Resonatorraum (23), die Kammern (24) und die den Resonatorraum (23) mit den Kammern (24) verbindenden Axialschlitze (25) von Aussparungen in einem in die Abschirmung (21) eingesetzten metallischen Körper (22) gebildet werden.

3. Resonatoranodnung nach Anspruch 2, dadurch gekennzeichnet, daß auf den Umfang des Resonatorraumes (54) eine Vielzahl Kammern (53) verteilt angeordnet ist.

4. Resonatoranordnung nach einem der vorhergehenden Ansprüche, dadurch gekennzeichnet, daß der Innendurchmesser der Abschirmung (21) so klein ist, daß die Grenzfrequenz des von der Abschirmung gebildeten Hohlleiterabschnittes höher ist als die Arbeitsfrequenz des Resonanzkreises.

5. Resonatoranordnung nach einem der vorhergehenden Ansprüche, dadurch gekennzeichnet, daß sie mit einer HF-Spule versehen ist, die an der Außenseite der Wandabschnitte (26) angeordnete, entweder jeweils einen von zwei einander gegenüberliegenden Axialschlitzen (25) umgebende oder einer von zwei in einander gegenüberliegenden Wandabschnitten (26) angeordneten Öffnungen (28) benachbarte Wicklungsabschnitte (27) aufweist.

6. Resonatoranordnung nach einem der Ansprüche 1 bis 4, dadurch gekennzeichnet, daß sie mit einer HF-Spule versehen ist, die parallel zu den offenen Enden des Resonatorraumes angeordnete Wicklungsabschnitte aufweist.

7. Resonatoranordnung nach Anspruch 5 oder 6, dadurch gekennzeichnet, daß die Wicklungsabschnitte (27) eine Helmholtzspule bilden.

8. Resonatoranordnung nach einem der vorhergehenden Ansprüche, dadurch gekennzeichnet, daß in wenigstens eine der Kammern ein dielektrisches oder metallisches Abstimmglied hineinragt.

9. Resonatoranordnung nach Anspruch 2 und/oder einem der Ansprüche 5 bis 8, dadurch gekennzeichnet, daß der Resonatorraum (54) des Resonanzkreises von einem einen Resonatorraum (63), Kammern und Axialschlitze eines zweiten Resonanzkreises enthaltenden Körper (61) in der Weise durchsetzt wird, daß die Achsen der Resonatorräume (54, 63) im wesentlichen senkrecht aufeinander stehen und die Enden des Resonatorraumes (63) des zweiten, inneren Resonanzkreises Öffnungen in den Wandabschnitten des ersten, äußeren Resonanzkreises gegenüberstehen.

10. Resonatoranordnung nach Anspruch 9, dadurch gekennzeichnet, daß der den inneren Resonanzkreis enthaltende Körper (61) an seinen Enden (62) um eine mit der Achse des Resonatorraumes (54) des äußeren Resonanzkreises im wesentlichen zusammenfallende Achse in den Wandungen der Abschirmung (51) drehbar gelagert ist.

11. Resonatoranordnung nach einem der vorhergehenden Ansprüche, dadurch gekennzeichnet, daß bei einem Durchmesser des Resonatorraumes (23, 32, 42, 54) von 6 mm der Durchmesser einer Kammer (24, 33, 43, 53) mindestens 5 mm, oder aber 7 mm oder 9 mm beträgt.

12. Resonatoranordnung nach einem der vorhergehenden Ansprüche, dadurch gekennzeichnet, daß der Durchmesser des Resonatorraumes (23, 32, 42, 54) höchstens etwa gleich, vorzugsweise aber kleiner ist als der Durchmesser einer Kammer (24, 33, 43, 53).

## Revendications

1. Montage résonateur, en particulier pour la spectroscopie RSE (Résonance de Spin Electronique), comportant un circuit de résonance qui présente au moins deux parois métalliques séparées par des fentes axiales, délimitant le pourtour d'une chambre de résonateurs, parois qui déterminent pour l'essentiel l'inductivité du circuit de résonance, alors que les faces frontales délimitant les fentes axiales des parois déterminent pour l'essentiel la capacité dudit circuit de résonance et comportant un blindage métallique entourant les parois, lesdites parois étant reliées audit blindage par une structure métallique qui forme des chambres axialement parallèles à la chambre de résonateurs et dont chacune communique par des fentes axiales avec la chambre de résonateurs et présente, dans le plan perpendiculaire à son axe, un pourtour qui est sensiblement supérieur à l'étendue de chacune des parois entre deux fentes axiales respectivement adjacentes, caractérisé par le fait qu'au moins deux parois (26) disposées face à face respectivement de la chambre de résonateurs (23) sont réduites, par des ouvertures (28) s'étendant dans le sens périphérique respectivement jusqu'aux fentes axiales (25), essentiellement à deux segments conducteurs respectivement parallèles par rapport à la direction axiale disposés aux extrémités de la chambre de résonateurs et dont la distance est approximativement égale au rayon de ladite chambre de résonateurs.

2. Montage résonateur selon la revendication 1, caractérisé par le fait que la chambre de résonateurs (23), les chambres (24) et les fentes axiales (25) reliant la chambre de résonateurs (23) aux chambres (24) sont formées par des évidements pratiqués dans un corps métallique (22) inséré dans le blindage (21).

3. Montage résonateur selon la revendication 2, caractérisé par le fait qu'une pluralité de chambres (53) est répartie sur le pourtour de la chambre de résonateurs (54).

4. Montage résonateur selon l'une des revendications précédentes, caractérisé par le fait que le diamètre intérieur du blindage (21) est si petit que la fréquence limite du segment-guide d'ondes formé par le blindage est supérieure à la fréquence opérationnelle du circuit de resonance.

5. Montage résonateur selon l'une des revendications précédentes, caractérisé par le fait qu'il comprend une bobine HF laquelle présente, disposés sur le côté extérieur des parois (26), des segments d'enroulement (27) qui soit entourent respectivement l'une des deux fentes axiales (25) disposées face à face soit sont situés de manière adjacente dans l'une de deux ouvertures (28) pratiquées dans des parois (26) se faisant face respectivement.

6. Montage résonateur selon l'une des revendications 1 à 4, caractérisé par le fait qu'il comprend une bobine HF laquelle présente des segments d'enroulement disposés parallèlement aux extrémités ouvertes de la chambre de résonateurs.

7. Montage résonateur selon la revendication 5 ou 6, caractérisé par le fait que les segments d'enroulement (27) forment une bobine de Helmholtz.

8. Montage résonateur selon l'une des revendications précédentes, caractérisé par le fait que dans au moins l'une des chambres pénètre un organe de syntonisation métallique ou diélectrique.

9. Montage résonateur selon la revendication 2 et/ou l'une des revendications 5 à 8, caractérisé par le fait que la chambre de résonateurs (54) du circuit de résonance est remplie par un corps (61) qui contient une chambre de résonateurs (63), des chambres et des fentes axiales d'un deuxième circuit de résonance de telle manière que les axes des chambres de résonateurs (54, 63) sont placés sensiblement perpendiculairement l'un sur l'autre et que les extrémités de la chambre de résonateurs (63) du deuxième circuit de résonance intérieur font face à des ouvertures pratiquées dans les parois du premier circuit de résonance extérieur.

10. Montage résonateur selon la revendication 9, caractérisé par le fait que le corps (61) contenant le circuit de résonance intérieur est monté dans les parois du blindage (51) de manière à tourner sur ses extrémités (62) autour d'un axe qui coïncide sensiblement avec l'axe de la chambre de résonateurs (54) du circuit de résonance extérieur.

11. Montage résonateur selon l'une des revendications précédentes, caractérisé par le fait qu'avec un diamètre de la chambre de résonateurs (23, 32, 42, 54) de 6 mm, le diamètre d'une chambre (24, 33, 43, 53) est égal à au moins 5 mm, mais peut être égal à 7 mm ou 9 mm.

12. Montage résonateur selon l'une des revendications précédentes, caractérisé par le fait que le diamètre de la chambre de résonateurs (23, 32, 42, 54) est au maximum égal mais de préférence inférieur au diamètre d'une chambre (24, 33, 43, 53).

## Claims

1. Resonance system, particularly for ESR spectroscopy, with a resonant circuit, which has at least two metallic wall sections separated by axial slots and defining the periphery of a resonance cavity, said wall sections essentially determining the inductance of the resonant circuit, whilst the faces of the wall sections defining the axial slots essentially determine the capacitance of the resonant circuit, and with a metallic screen surrounding the wall sections, the latter being connected to the screen by a metallic structure, which form chambers axially parallel to the resonance cavity, whereof each is connected via axial slots to the resonator cavity and in the plane at right angles to the axis thereof has a periphery, which is substantially larger than the extension of each of the wall sections between in each case two adjacent axial slots, characterized in that at least two facing wall sections (26) of the resonance cavity (23) are reduced by openings (28) circumferentially extending up to the axial slots (25) to essentially two line portions arranged in parallel, with respect to the axial direction, at the ends of the resonance cavity and whose spacing is approximately the same as the radius of the resonance cavity.

2. Resonance system according to claim 1, characterized in that the resonance cavity (23), the chambers (24) and the axial slots (25) connecting the resonance cavity (23) to the chambers (24) are formed by recesses in a metallic body (22) inserted in the screen (21).

3. Resonance system according to claim 2, characterized in that a plurality of chambers (53) is distributed over the circumference of the resonance cavity (54).

4. Resonance system according to one of the preceding claims, characterized in that the inside diameter of screen (21) is so small that the cut-off frequency of the waveguide portion formed by the screen is higher than the working frequency of the resonant circuit.

5. Resonance system according to one of the preceding claims, characterized in that it is provided with a HF coil, having on the outside of the wall sections (26) either one of two openings (28) of adjacent winding sections (27) surrounding facing axial slots (25) or one of two openings (28) of adjacent winding sections (27) arranged in facing wall sections (26).

6. Resonance system according to one of the claims 1 to 4, characterized in that it is provided with a HF coil having winding sections parallel to the open ends of the resonance cavity.

7. Resonance system according to claims 5 or 6, characterized in that the winding sections (27) form a Helmholtz coil.

8. Resonance system according to one of the preceding claims, characterized in that a dielectric or metallic tuning element projects into at least one of the chambers.

9. Resonance system according to claim 2 and/or one of the claims 5 to 8, characterized in that the resonance cavity (54) of the resonant circuit is traversed by a body (61) containing a resonance cavity (63), chambers and axial slots of a second resonant circuit in such a way that the axes of the resonance cavities (54, 63) are substantially vertically above one another and the ends of the resonance cavity (63) of the second, inner resonant circuit face openings in the wall sections of the first, outer resonant circuit.

10. Resonance system according to claim 9, characterized in that the body (61) containing the inner resonant circuit is rotatably mounted at its ends (62) about an axis in the walls of screen (51) substantially coinciding with the axis of the resonance cavity (54) of the outer resonant circuit.

11. Resonance system according to one of the preceding claims, characterized in that in the case of a diameter of the resonance cavity (23, 32, 42, 54) of 6 mm, the diameter of one chamber (24, 33, 43, 53) is at least 5 mm, or 7 mm, or 9 mm.

12. Resonance system according to one of the preceding claims, characterized in that the diameter of the resonance cavity (23, 32, 42, 54) is at the most roughly the same and preferably somewhat smaller than the diameter of a chamber (24, 33, 43, 53).

Fig. 1

Fig. 2

Fig. 3